# EUROPEAN PATENT APPLICATION

(11) **EP 2 378 587 A1**
(43) Date of publication of application: **19.10.2011**
(21) Application number: 11170016.7
(22) Date of filing: 13.07.2007
(51) Int. Cl.: H01L 51/50

(54) **A hybrid organic light emitting device**

(30) Priority: 14.07.2006 GB 0614083
(62) Divisional of application: 07766229.4
(71) Applicant: Imperial Innovations Limited, London SW7 2AZ (GB)
(72) Inventor: Haque, Saif Ahmed, London, SW7 2AZ (GB); Durrant, James Robert, London, SW7 2AZ (GB); Bradley, Donal, Beaconsfield,, Buckinghamshire HP9 2QH (GB)
(74) Representative: Roberts, Gwilym Vaughan

(57) **Abstract**

A hybrid organic light emitting device comprises an anode (302), a cathode (300), and an emissive layer (306) there between. The cathode (300) is formed of a transparent conductive oxide.

## Description

The invention relates to a hybrid organic light emitting device (OLED)

Research in OLEDs is being carried out in a number of areas, for example application of such devices in solid-state lighting sources and display technologies and increasing interest is being shown in the internal structure and methodology of active layers within the device which can be shown to enhance device performance.

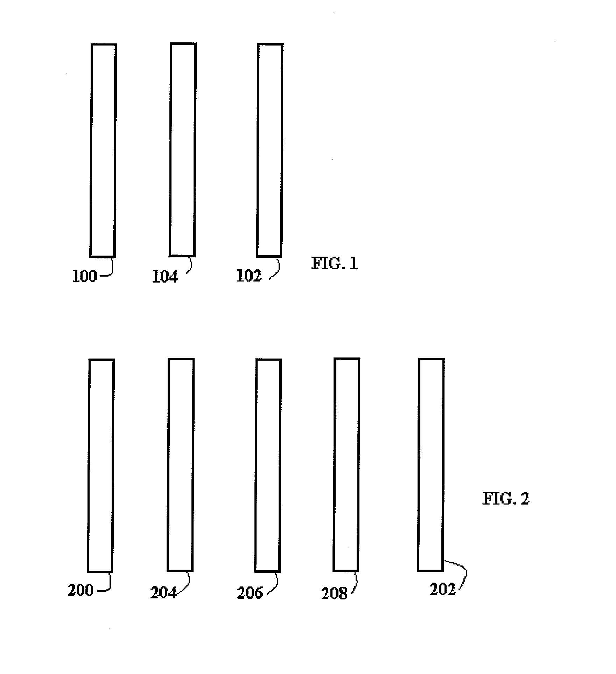

A simple OLED is shown in Fig 1 including a cathode 100 and an anode 102 between which an emissive layer 104 comprising a light emitting polymer such as poly-para - (phenylene vinylene)(PPV) is sandwiched. In operation the cathode injects electrodes into the emissive layer and the anode injects holes into, that is to say, removes electrons from the emissive layer. During electrode injection the electrodes enter the lowest unoccupied molecular orbital (LUMO) of the emissive layer and holes are injected into the highest occupied molecular orbital (HOMO) of the emissive layer. The electrons and holes are transported across the emissive layer and are recombined by transition of the electrodes in the LUMO down to the holes in the HOMO. This exciton recombination generates a photon providing the emissive properties of the device.

In order to overcome the potential difference between the Fermi energy of the cathode and anode and the LUMO and HOMO respectively of the emissive layer, a forward bias is applied across the device. To increase electron injection efficiency a low work function metal is selected for the cathode for example magnesium, barium or calcium hence providing a low level of electron dissociation. The anode is typically formed of indium tin oxide (ITO) whose conductivity allows addressing of the OLEDs to obtain pixellated emission, and whose transparency allows the photons to escape. The ITO is typically treated to ensure that hole injection matches electron injection as otherwise electrons will pass through the emissive layer into the anode, generating a leakage current. For example the ITO can be submitted to an ultraviolet-ozone cleaning treatment to lower its Fermi level. It is further known to dope the emissive layer to increase the proportion of photon inducing recombination.

Existing OLED developments are described in "Organic Light Emitting Devices - from Displays to Lighting" by Parthasarathy et al published in the Electro Chemical Society Interface, Summer 2003 Edition. A further improvement is described therein allowing the decoupling of carrier injection and carrier transport roles in an OLED from the recombination role. In particular, as shown in Fig. 2, in addition to a cathode 200 and anode 202, an electron transport layer 204 is provided intermediate the cathode and the emissive layer 206 and a hole transport layer 208 is provided intermediate the anode and the emissive layer 206 providing a three layer structure. As a result the HOMO and LUMO respectively of the transport layers can be tailored without compromising the emissive properties of the emissive layer to improve injection and transport into the emissive layer.

In a further approach described in "Electroluminescence from Single Monolayers of Nanocrystals in Molecular Organic Devices" by Coe et al published in Nature, Volume 420, page 800, 19/26 December 2002, a hybrid OLED is described including an inorganic emissive layer sandwiched between organic carrier transport layers.

A problem with existing approaches are that a low work function metal is required for the cathode meaning that reactive metals are required. Typically vacuum deposition is required for three layer devices, and deposition of an organic material onto the ITO anode is required which can damage the ITO. Furthermore, treatment of the anode is required to ensure sufficient hole injection. Yet further the efficiency/emissivity of the device is limited by the size of the interface between the transport layers and the emission layer.

The invention is set out in the claims.

Embodiments of the invention will now be described, by way of example, with reference to the drawings of which:
Fig. 1 is a schematic device of a simple single layer OLED;
Fig 2 is a schematic diagram of a multi-layer OLED;
Fig 3 is a schematic diagram showing an OLED according to the present invention; and
Fig 4 is a diagram showing energy levels of the various layers according to the present invention.

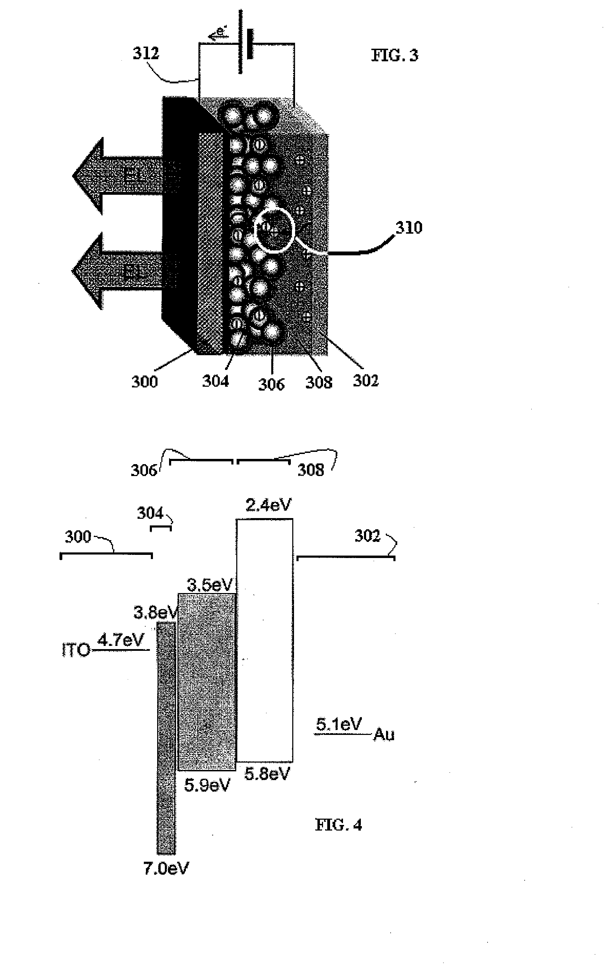

In overview according to the present invention a hybrid inorganic/organic light emitting device or diode. Referring to Fig. 3 the device comprises a cathode 300 and an anode 302 between which is sandwiched a nanocomposite film comprising three structurally organised phases. The first phase comprises an electron transport layer 304 adjacent the cathode and comprising a mesoporous nanocrystalline or planar titanium dioxide (Ti0₂) film. The film is coated with an emissive layer comprising a thin layer of an electroluminescent material shown generally at 306. An organic hole transporting polymer comprises the hole transport layer 308 adjacent the anode and is interpenetrated into the TiO₂ film pores. Hence the device forms a hybrid OLED, with organic emissive and hole transporting layers and an inorganic electron transporting layer. A forward bias is applied at 312.

Significantly this allows the cathode to be formed of a transparent conducting oxide such as ITO whereas in prior art devices ITO has formed the anode. In particular this is achieved because of the use of TiO₂ as the electron transport layer. In addition to being a good electron transporting material TiO₂ conduction band energy level can be modulated by adjusting surface charge of TiO₂ film., providing a good energy level match with the adjacent cathode and emissive layers. In addition the TiO₂ film serves the function of electron transport and injection into the emissive layer and provision of a desirable active layer morphology.

As a result electro-active structures can be developed combining the diversity of organic materials with the high performance electrical and structural properties of inorganic materials. The three component architecture isolates the luminescence processes from the charge carrier transport, allowing each process to be optimised individually. In some instances a two layer structure can be implemented where, for example, the hole transporting and emitter functions are performed by the same material. Light emitting devices based upon the multi component hybrid nanocomposite films described according to the invention herein have been found to provide significant luminescence brightness. Furthermore, because of the reversal of operation the device structure is less sensitive to the properties of the ITO substrate such that alternative, cheaper substrates such as fluorine-doped tin oxide coated glass layers can be used.

Turning to the invention in more detail, the device comprises an ITO coated glass electrode (cathode) and, as anode, a gold contact. The TiO₂ is functionalised with a thin layer of the electroluminescent material and the organic hole transporting polymer interpenetrated into the film pores. The electroluminescent material or polymer may be, for example Red-F or, F8BT poly(9,9-dioctylfluorene-co-benzothiadiazole) all available from Sumitomo Company of Japan and the hole transporting organic polymer can be PFO poly(9,9-dioctylfluorene) .

The operation of the invention can be further understood with reference to Fig. 4 which is a diagram of the energy levels for the ITO/ TiO₂/F8BT/PFO/AU device shown in Fig. 3. Electrons are injected from the ITO contact via the conduction band of the nanocrystalline TiO₂ into the LUMO of the F8BT material. Similarly holes are injected from the gold contact via the PFO hole transport layer into the HOMO of the F8BT. By way of these two interfacial charge transfer reactions, F8BT excitons are generated in the interface layer and radiatively recombined to emit light as shown in Fig. 3 at 310.

The Fermi level of the ITO is 4.7eV, the LUMO of the TiO₂ is 3.8eV, and the LUMO of the PFB8 is 3.5eV. As can be seen, therefore, the energy levels are such that electron transport into the LUMO of the F8BT is permissible. The Fermi level of the gold contact is 5.1eV, the HOMO of the PFO is 5.8eV and the HOMO of the F8BT is 5.9eV once again allowing hole injection transport into the emissive layer. At the emissive layer, electrons in the LUMO decay to the HOMO generating photons. Of course the various material properties can be tuned to obtain different wavelengths; for example the architecture described with reference to Fig 4 provides red light. In order for charge carrier injection, an appropriate forward potential is required to function. There is a leV barrier for electron injection from the ITO into the conduction band of the TiO₂ and a further 0.3eV barrier to electron injection from the transport level of TiO₂ into the LUMO of F8BT. In addition there is a 0.7eV barrier to hole injection from the gold into the PFO and a further O.1eV barrier from the PFO transport level into the HOMO of the F8BT. Of course it will be recognised that alternative material choice or optimisation will lead to a reduction in the barriers which in turn would lead to improvements in the voltage required to obtain the necessary forward bias, as well as the overall efficiency of the device.

The selection of TiO₂ or equivalent metal oxides such as zinc oxide (ZnO) and tin oxide (SnO₂) is desirable in view of the good electron transporting properties as well as low cost, good stability, ease of fabrication and ease of morphology control at the nanocrystalline level. In addition, the use of a metal oxide allows the reversal of the function of ITO such that it can be used as the cathode rather than the anode. Furthermore this means that a high work function metal such as gold or platinum or other material such as PEDOT-PSS poly(3,4-ethylene-dioxythiophene)-poly(styrene sulphonate) can be provided as hole transporting and injecting layer at the anode providing increased stability. Of course appropriate additives or interface layers can be introduced to enhance stability and performance of the TiO₂ although it is found that the metal oxide layer is inherently relatively insensitive to molecular oxygen induced photo degradation compared to organic polymer based devices.

In a typical HYLED device fabrication a ∼ 150 nm thick nanocrystalline TiO₂ film is deposited on a plasma etched, patterned indium tin oxide (ITO) obtained for example from CRL apto substrate by spin coating from a colloidal solution of TiO₂ particles in water. After air drying the electrode was fired for 3 0 mins at 450°C. The resulting film is then coated with an ultra-thin layer of F8BT electroluminescent polymer by immersion in a chlorobenzene solution containing 0.05M of the F8BT polymer for 1 hour, under nitrogen at 65°C. Following deposition, this layer is remarkably stable, with for example subsequent immersion of the film in neat chlorobenzene resulting in negligible desorption. The pores of the coated film are then filled by a PFO organic hole transporting material by spin coating from a chloroform solution containing 0.1M of the polymer, giving a structurally organized three component nanostructured film. To complete the device fabrication gold top electrodes are evaporated in 3x10⁻⁶ torr vacuum at a rate of 10 ÅS⁻¹ (thickness ∼ 100nm) through a shadow mask, which defines the device active area (0.02 cm²).

As a result of the approaches described herein, a three component architecture is achieved isolating the luminescence processes from electron and hole charged transport allowing the possibility of each component to be optimised separately. Use of a mesoporous nanocrystalline metal oxide film enables the interfaces within the active device layer to be optimised at the nanometer length scale. As a result of the high interface area of the interpenetrating network junction with the F8BT, higher coverage is achieved, and high emission intensities are available at low current densities, enhancing the power conversion efficiency and long term performance. These high surface area mesoporous films can be modified by the attachment of molecular dyes, polymers or biomolecules. The turn-on voltage is found to be reduced consistent with a reduction in the energy barrier to electron injection at the TiO₂/F8BT interface. Device efficiency is also observed believed to result from improved electron injection from the TiO₂ cathode into the LUMO of the F8BT. Furthermore the use of metal oxides allows the potential of room temperature fabrication for example by spin coating and avoids problems previously encountered in depositing potentially aggressive polymer materials onto the ITO substrate.

It will be appreciated that any appropriate cathode and anode material can be implemented meeting the requirements set out above and similarly any appropriate metal oxide for example a mesoporous nanocrystalline metal oxide can be used as electrical transport layer. Similarly, any appropriate emissive layer and hole transport layer can be implemented and the various properties tuned to provide emitted light at an appropriate wavelength. Additional transport or emissive layers can be added as appropriate. Reference to layers throughout includes physically independent layers and interpenetrated layers as appropriate.

In a first alternative embodiment there is provided a hybrid organic light emitting device comprising an anode, a cathode, respective adjacent hole and electron transport layers and an emissive layer therebetween, in which the electron transport layer comprises a metal oxide.

Optionally, the metal oxide comprises one of titanium oxide, zinc oxide or tin oxide

Optionally, the cathode comprises a transparent electrically conducting oxide.

Optionally, the transparent electrically conducting oxide comprises Indium Tin Oxide.

Optionally, the anode comprises a high work function metal.

Optionally, the high work function metal comprises one of gold, platinum or PEDOT-PSS.

In a second alternative embodiment there is provided a hybrid organic light emitting device comprising a mesoporous electron transport layer.

In a third alternative embodiment there is provided a hybrid organic light emitting device comprising an anode, a cathode, and at least one layer therebetween performing hole transport, electron transport and emission functions, in which a metal oxide provides electron transport.

In a fourth alternative embodiment there is provided a method of fabricating a hybrid organic light emitting device comprising depositing a layer of metal oxide on a transparent conducting oxide cathode, depositing an emissive layer on or interpenetrated into the metal oxide layer, depositing a hole transport layer on or interpenetrated into the metal oxide and emissive layer, and forming an anode on the hole transport layer.

Optionally, the metal oxide is mesoporous or a planar film.

## Claims

1. A hybrid organic light emitting device comprising an anode, a cathode and an emissive layer therebetween in which the cathode comprises a transparent electrically conducting oxide.

2. A device as claimed in claim 1 in which the transparent electrically conductive oxide comprises Indium Tin Oxide.

3. A device as claimed in claim 1 or claim 2 in which the anode comprises a high work function metal.

4. A device as claimed in claim 3 in which the high work function metal comprises gold, platinum or PEDOT-PSS

5. A device as claimed in any of claims I to 4 further comprising an electron transport layer between the cathode and the emissive layer.

6. A device as claimed in claim 5 in which the electron transport layer comprises a metal oxide.

7. A device as claimed in claim 6 in which the metal oxide comprises one of titanium oxide, zinc oxide or tin oxide.

8. A device as claimed in claim 5 in which the electron transport layer comprises a mesoporous layer.

9. A device as claimed in claim 5 in which the electron transport layer comprises a nanocrystalline structure.

10. A device as claimed in claim 5 in which an emissive layer material is interpenetrated into the electron transport layer.

11. A device as claimed in any of claims 1 to 4 further comprising a hole transport layer between the emissive layer and the anode.

12. A device as claimed in any of claims 5 to 11 in which one of the hole and electron transport layers also acts as emissive layer.

13. A method of fabricating a hybrid organic light emitting device comprising depositing an emissive layer on a transparent conductive oxide cathode, and forming an anode on the emissive layer.

14. A method as claimed in claim 13 in which the metal oxide is mesoporous or a planar film.
